# EUROPEAN PATENT APPLICATION

(11) **EP 1 890 337 A2**
(43) Date of publication of application: **20.02.2008**
(21) Application number: 07016284.7
(22) Date of filing: 20.08.2007
(51) Int. Cl.: H01L 31/042

(54) **Laminating apparatus**

(30) Priority: 18.08.2006 JP 2006223313
(71) Applicant: NPC Incorporated, Arakawa-ku, Toyko 116-0003 (JP)
(72) Inventor: Chikaki, Yoshiro, Arakawa-ku Tokyo 116-0003 (JP)
(74) Representative: Jacoby, Georg

(57) **Abstract**

In a laminating apparatus which heats, and sandwiches and presses an object to be laminated, a plurality of heaters are provided inside a heater panel, temperature sensors are respectively provided in part or all of a plurality of heating zones formed by dividing a top surface of the aforesaid heater panel, and a control device which individually controls the plurality of heaters based on a measurement result of the aforesaid temperature sensors is included.

## Description

### Background of the Invention

### 1. Field of the Invention

The present invention relates to a laminating apparatus particularly suitable for producing a laminated object in a thin plate shape such as a solar battery module.

### 2. Description of the Related Art

In recent years, various developments have been made with respect to solar batteries. The solar batteries have various forms, and a crystal type using single crystal silicon and polycrystalline silicon, an amorphous type using amorphous silicon (noncrystal silicon) and the like are contrived. However, each type of solar battery easily causes a chemical change and has the property susceptible to a physical impact. Therefore, solar battery modules formed by laminating solar batteries with transparent vinyl films, reinforced glass, heat-resistant glass and the like are generally used. Lamination of a solar battery module is performed by inserting a string (solar battery cell) between a vinyl film or glass and a back sheet via a filler such as, for example, an EVA (ethylene vinyl acetate) resin, and melting the filler inside the object to be laminated by heating it under vacuum.

Conventionally, as a laminating apparatus for producing such solar battery modules and the like, a laminating apparatus having an upper chamber including a diaphragm expandable downward and a lower chamber including a heater panel is publicly known. Such a laminating apparatus has a constitution in which after the upper chamber and the lower chamber are hermetically sealed and decompressed to be under vacuum (low pressure), atmosphere is introduced into the diaphragm, and thereby, the solar battery module is sandwiched and pressed between the diaphragm and the heater panel, and heated by the heater panel.

In the laminating apparatus disclosed in Patent Document 1, a plurality of heaters are provided inside the heater panel to heat the solar battery module uniformly (see Japanese Patent Application Laid-open No. 2004-31739).

### Summary of the Invention

However, the laminating apparatus disclosed in the above described Patent Document 1 has the possibility of ununiformly heating the solar battery module which is an object to be laminated like heating, for example, the central side of the heater panel more than the end portion side due to the arrangement of the heaters provided inside the heater panel. Further, the laminating apparatus disclosed in the above described Patent Document 1 can uniformly heat the solar battery module in a predetermined shape and size, but in the case of heating the solar battery module in a shape and size different from the predetermined shape and size, it has the possibility of ununiformly heating the solar battery module and being incapable of properly producing the solar battery module. Like this, in the above described Patent Document 1, the shape and size of the solar battery modules which can be properly produced are extremely limited.

The present invention is made in view of the above described problem, and has an object to provide a laminating apparatus capable of always heating an object to be laminated uniformly irrespective of the shape and size of the laminated object to be produced, and capable of properly producing various kinds of laminated objects.

To attain the above described object, according to the present invention, there is provided a laminating apparatus which heats, and sandwiches and presses an object to be laminated, characterized by including a heater panel including a plurality of heaters inside, temperature sensors each disposed in part or all of a plurality of heating zones formed as a result of dividing a top surface of the aforesaid heater panel into the plurality of heating zones, and a control device which individually controls the plurality of heaters based on a measurement result of the aforesaid temperature sensors.

In the above described laminating apparatus, the object to be laminated may be a solar battery module.

In the above described laminating apparatus, the plurality of heaters may be heaters each in a lengthy shape disposed to be parallel with each other inside the aforesaid heater panel.

In the above described laminating apparatus, the plurality of heaters may be constituted so that heaters which perform heating in a central portion of the aforesaid heater panel and heaters which perform heating at both end portions are alternately disposed along a predetermined direction.

In the above described laminating apparatus, the plurality of heating zones may include at least a heating zone in a central portion and heating zones at both end portions of the aforesaid heater panel.

In the above described laminating apparatus, an auxiliary heater individually controllable based on the measurement result of the aforesaid temperature sensors may be provided on an undersurface of the aforesaid heater panel.

### Brief Description of the Drawings

FIG 1 is a plane view of a laminating apparatus 1 according to an embodiment of the present invention;
FIG 2 is a side view of the laminating apparatus 1 according to the embodiment of the present invention;
FIG 3 is a sectional view taken along the arrows A to A in FIG 1;
FIG 4 is an explanatory view showing an operation of a laminating part;
FIG 5 is a plane view of a heater panel 35;
FIG 6 is a side view of the heater panel 35; and
FIG 7 is an enlarged sectional view showing long heaters 41 inserted and installed in a long hole 40A shown in FIG 5 by cutting them by a horizontal plane passing through the axis of the long hole 40A;
FIG 8 is a sectional view schematically showing the structure of the heater 41A at the left side out of the two heaters 41A shown in FIG 7;
FIG 9 is a schematic diagram showing the relationship of temperature sensors 42 disposed on the heater panel 35, and heating zones Z1 to Z18 of which temperatures these temperature sensors 42 measure;
FIG 10 is a plane view of a solar battery module M;
FIG 11 is an enlarged sectional view of the solar battery module M;
FIG 12 is an explanatory view showing one example of the positional relationship of the heating zones Z1 to Z18 shown in FIG 9 and the solar battery module M;
FIG 13 is an explanatory view showing one example of the positional relationship of the heating zones Z1 to Z18 shown in FIG. 9 and the solar battery module M; and
FIG. 14 is a schematic diagram showing a part of the constitution of the laminating apparatus 1 according to a second embodiment of the present invention.

### Detailed Description of the Invention

Hereinafter, preferred embodiments of the present invention will be described based on a laminating apparatus 1 favorable for performing laminate treatment for a solar module M as an example of an object to be laminated. In this specification and the drawings, the components practically having the same functions and constitutions are given the same reference numerals and characters, and the redundant explanation of them will be omitted.

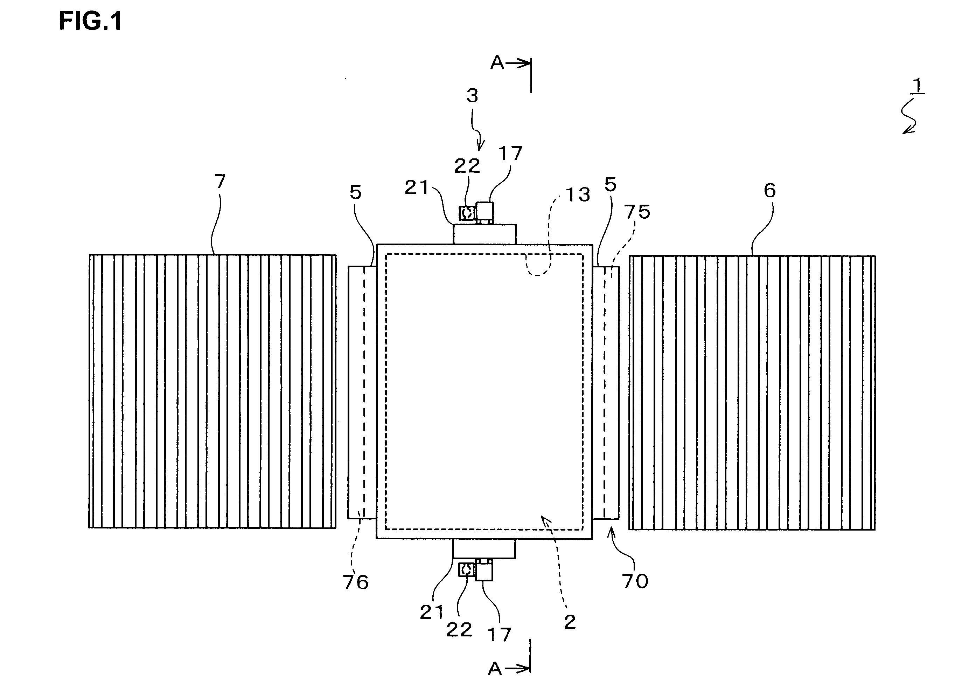

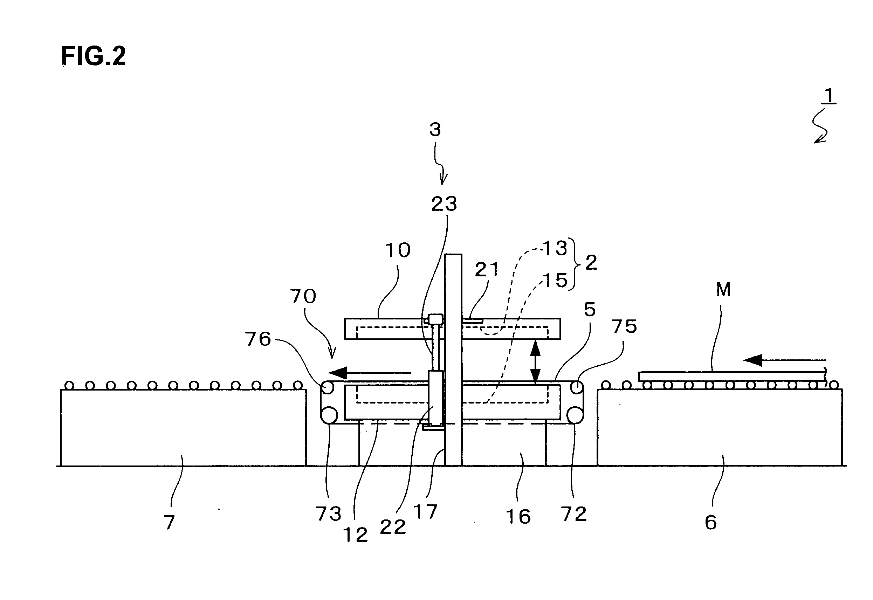

FIG 1 is a plane view of the laminating apparatus 1 according to the embodiment of the present invention. FIG. 2 is a side view of the laminating apparatus 1 according to the embodiment of the present invention. As shown in FIGS. 1 and 2, the laminating apparatus 1 includes a laminate unit 3 including a laminating part 2 inside. The laminating part 2 is formed in such a size to be able to laminate an object to be laminated in a size about 2150 mm wide in the lateral direction and about 4000 mm wide in the direction toward the rear surface from the front surface at the maximum, for example.

The laminating apparatus 1 includes a conveying sheet 5 which enters the laminate unit 3 with the solar battery module M carried thereon. A supply conveyor 6 which conveys the solar battery module M to be subjected to the laminate treatment toward the laminate unit 3 is disposed on the right of the laminate unit 3. An unloading conveyor 7 which conveys the solar battery module M from the laminate unit 3 side is disposed on the left of the laminate unit 3. The solar battery module M is conveyed leftward in FIGS. 1 and 2 as it is transferred to and from the supply conveyor 6, the conveying sheet 5 and the unloading conveyor 7 in sequence.

As shown in FIG. 2, the laminate unit 3 includes an upper case 10 and a lower case 12. An upper chamber 13 is formed in a lower side of an inside of the upper case 10, and a lower chamber 15 is formed in an upper side of an inside of the lower case 12. The laminating part 2 is constituted of the upper chamber 13 and lower chamber 15.

The lower case 12 is fixedly supported at an upper side of a base 16. Brackets 21 movable along support pillars 17 vertically provided at a front face side and a back face side (a front side and a rear side in FIG. 2) of the base 16 are included, and the front face side and the back face side of the upper case 10 are respectively fixed to the brackets 21. Thereby, the upper case 10 rises and lowers along the support pillars 17, and is constituted to be risible and lowerable above the lower case 12 while keeping a posture parallel with the lower case 12.

A hydraulic cylinder 22 is fitted to a side of the support pillar 17, and a tip end of a piston rod 23 of the cylinder 22 is connected to an undersurface of the bracket 21 fixed to the upper case 10. Accordingly, when the piston rod 23 extends by operation of the cylinder 22, the upper case 10 rises to separate from the top surface of the lower case 12, and thereby, the laminating part 2 constituted of the upper chamber 13 and the lower chamber 15 is in an open state. On the other hand, when the piston rod 23 contracts by operation of the cylinder 22, the upper case 10 lowers to be in close contact with the top surface of the lower case 12, and the laminating part 2 is in a hermetically sealed state.

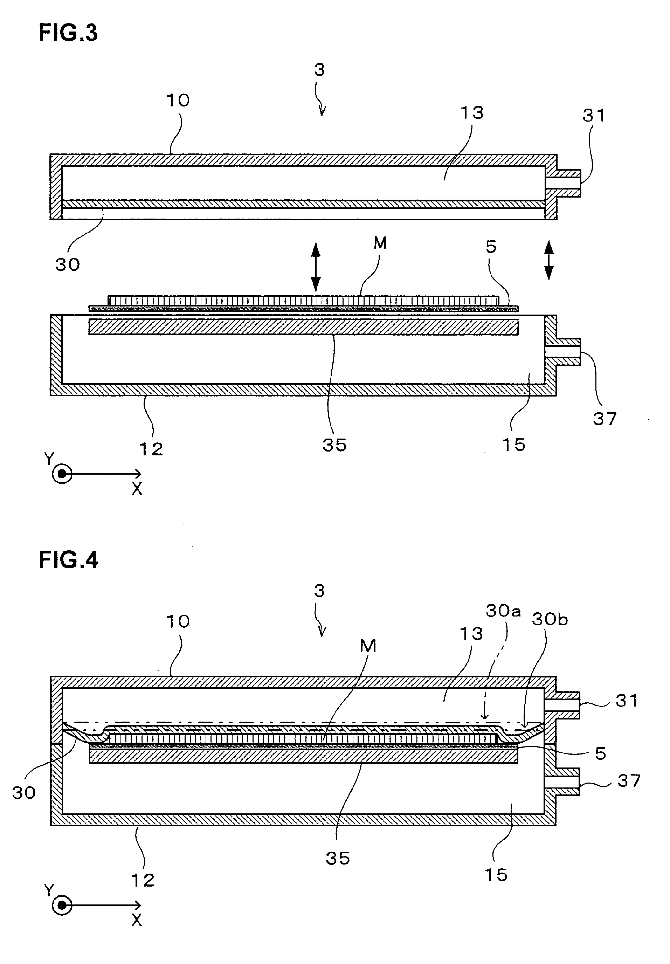

FIG 3 is a sectional view taken along the arrows A-A in FIG. 1. An arrow direction X shown in FIG 3 shows the longitudinal direction of the heater panel 35 (specifically, the lengthwise direction of a heater 41 which will be described later), and an arrow direction Y shows a lateral direction orthogonal to the longitudinal direction X of the heater panel 35 (namely, the loading and unloading direction of the solar battery module M). As shown in FIG. 3, a diaphragm 30 is fitted in such a way as to partition the inside of the upper case horizontally, and a first space enclosed by the diaphragm 30 and an inner wall surface of the upper case 10 constitutes the upper chamber 13. As the diaphragm 30, for example, a silicon diaphragm, a butyl diaphragm and the like are used. An inlet/outlet port 31 is provided in a side surface of the upper case 10 to communicate with the upper chamber 13, so that the inside of the upper chamber 13 is evacuated through the inlet/outlet port 31, and atmospheric pressure can be introduced into the upper chamber 13 through the inlet/outlet port 31.

A heater panel 3 5 is disposed inside the second space enclosed by the diaphragm 30 and the inner wall surface of the lower case 12. The heater panel 35 has a constitution in which heaters 41 are provided inside a metal plate 36 made of aluminum, for example, as will be described later. The solar battery module M carried to a position above the heater panel 3 5 by the conveying sheet 5 is constituted to be able to be lifted from the conveying sheet 5 and placed on the conveying sheet 5 by being raised and lowered by a raising and lowering mechanism (not shown) using a pin.

An inlet/outlet port 37 is provided in a side surface of the lower case 12 to communicate with the lower chamber 15, so that the inside of the lower chamber 15 is evacuated through the inlet/outlet port 37, and atmospheric pressure can be introduced into the lower chamber 15 through the inlet/outlet port 37.

FIG. 4 is a view showing the state in which the upper chamber 10 is lowered from the state shown in FIG. 3, and is brought into close contact with the top surface of the lower case 12 to seal the laminating part 2 hermetically. When an internal pressure difference is caused by using the inlet/outlet ports 31 and 37 in the hermetically sealed state shown in FIG. 4 so that the internal pressure of the upper chamber 10 becomes larger than the internal pressure of the lower chamber 15, the diaphragm 30 changes from the sate shown by the two-dot chain line 30a in FIG. 4 to the state shown by the solid line 30b in FIG. 4, to sandwich and press the object to be laminated M against the heater panel 35.

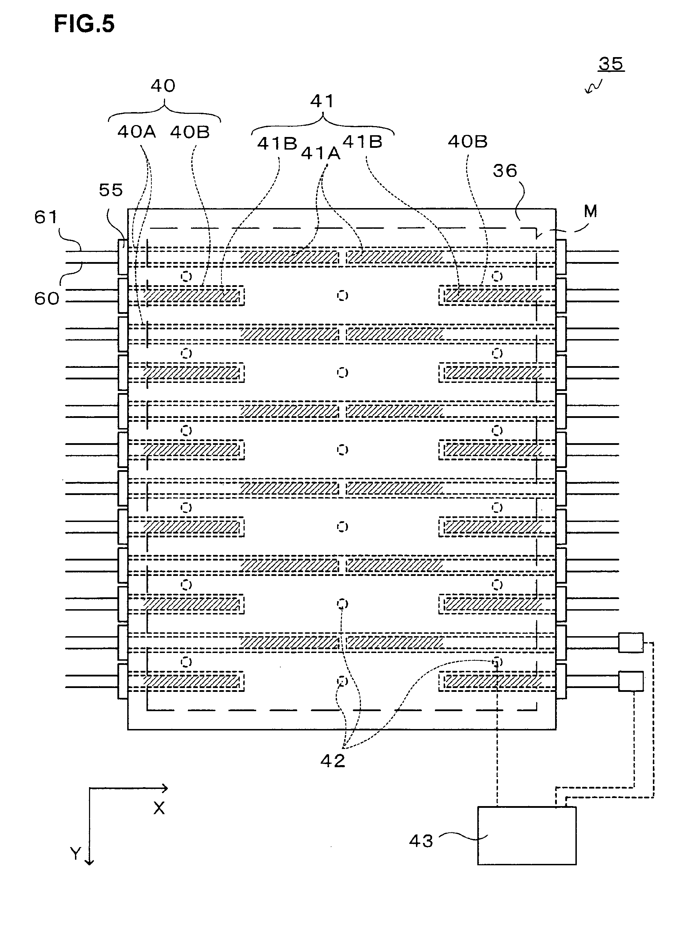

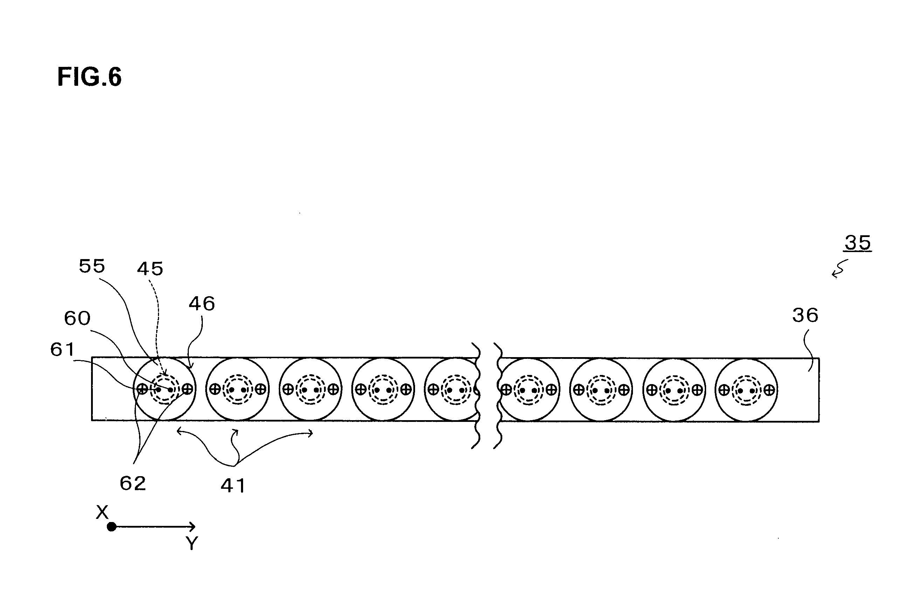

Next, a structure of the heater panel 35 will be described. FIG. 5 is a plane view of the heater panel 35. FIG 6 is a side view of the heater plate 35.

As shown FIGS. 5 and 6, inside the metal plate 36 of the heater panel 35, 24 rod heaters 41 (41A, 41B) are disposed parallel with each other along the top surface of the heater panel 35. These 24 heaters 41 have the constitution in which pairs of long heaters 41A opposed to each other on the same straight lines parallel with the longitudinal direction X and pairs of heaters 41B which are shorter than the heaters 41A and opposed to each other on the same straight line parallel with the longitudinal direction X are alternately disposed equidistantly along the lateral direction Y of the heater panel 35. The long heaters 41A and the short heaters 41B are disposed along the longitudinal direction X of the heater panel 35. The 12 long heaters 41 A all have the same lengths in the longitudinal direction X (specifically, the lengthwise direction X), and the 12 short heaters 41B all have the same lengths in the longitudinal direction X (specifically, the lengthwise direction X).

The pair of long heaters 41A have an arrangement constitution such that they are installed by being inserted into a long hole 40A penetrating through the heater panel 35 in the longitudinal direction X from both sides, and a predetermined space is allowed between tip end portions of each other. In this embodiment, the hole 40A has a section in a perfect circle shape. The predetermined space between the tip end portions is preferably set at a value as small as possible of the values at which the tip ends of the heater 41A do not collide with each other in consideration of the length by which the heater 41A expands in the longitudinal direction X during heating. In this embodiment, a heat generating portion of the long heater 41A is disposed at a central side in the longitudinal direction X of the heater panel 35 as shown by the diagonally shaded portions in FIG 5. Thereby, heating by the pair of long heaters 41 A is constituted to be performed at the central side in the longitudinal direction X of the heater panel 35 and not to be performed at both end portion sides.

The pair of short heaters 41B are respectively inserted and installed in holes 40B respectively provided at both end sides in the longitudinal direction X of the heater panel 35. The hole 40B is in such a shape that one end at the central side in the longitudinal direction X of the heater panel 3 5 is closed and the other end is opened. The closed end portion of the hole 40B is disposed at the same position as a position of a boarder of the heat generating portion and a non-heat generating portion of the long heater 41A in the longitudinal direction X. In this embodiment, the hole 40B has a section in a perfect circular shape. A heat generating portion of the short heater 41B is disposed over the entire length of the short heater 41B as shown by the diagonally shaded portions in FIG. 5, and heating by the pair of short heaters 41B is constituted to be performed at both end portions in the longitudinal direction X of the heater panel 35.

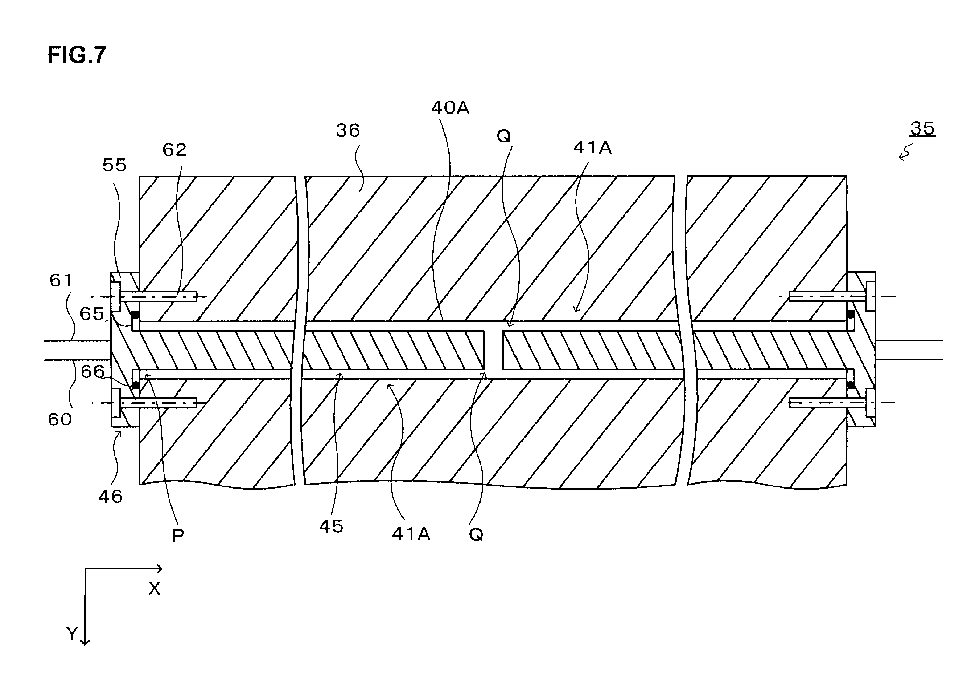

FIG. 7 is an enlarged sectional view showing the long heater 41A inserted and installed in the hole 40A shown in FIG 5 by cutting it by the horizontal surface passing the axis of the hole 40A and enlarging it. In the following, the hole 40A and the long heater 41A will be described, and the hole 40B and the short heater 41B are constituted substantially similarly to them. As shown in FIG. 7, the two heaters 41A inserted and installed in each of the holes 41A are disposed along the lengthwise direction X of the hole 40A, and are respectively supported at both the end portion sides of the hole 40A.

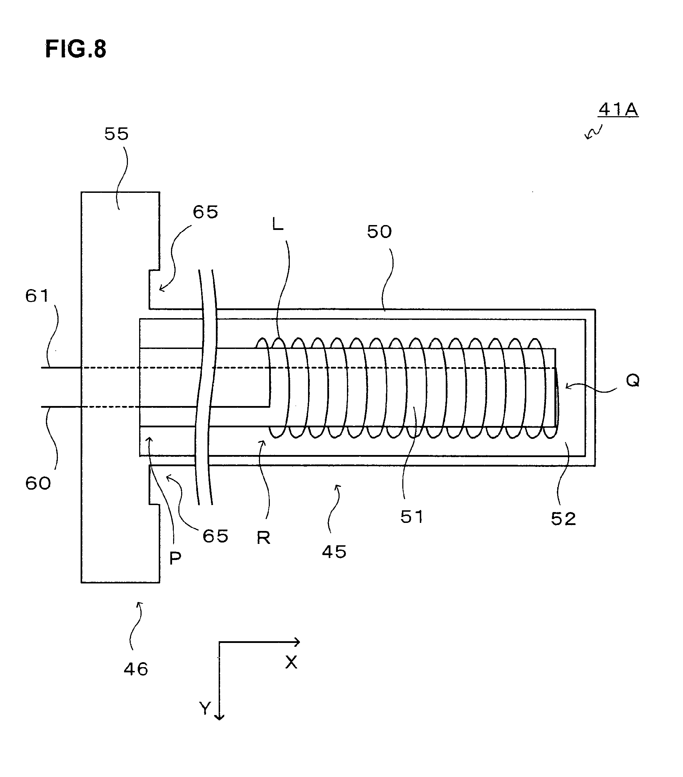

In this embodiment, a cartridge heater is used as the heater 41 A. As shown in FIG 7, the heater 41A has the constitution in which a flange portion 46 having a diameter larger than a diameter of a heating portion is provided at one end of a cylindrical heating portion 45. FIG. 8 is a sectional view schematically showing a structure of the heater 41A at the left side of the two heaters 41A shown in FIG. 7. As shown in FIG. 8, the heating portion 45 of the heater 41A has a constitution in which a columnar core 51 constituted of, for example, sintered magnesia or the like is concentrically disposed inside a hollow metal tube 50. As the metal tube 50, for example, iron, brass, copper, stainless steel, inconel and the like may be used. One end of the metal tube 50 is closed, and the other end is connected to a metal disk 55 of the flange portion 46 and is hermetically sealed. Insulating powder 52 with a high thermal conductivity is filled between the metal tube 50 and the core 51.

One continuing lead wire L is wound on an outer peripheral surface of the core 51 in a spiral form. The lead wire L is linearly laid to an intermediate portion R near the center of the core 51 along the lengthwise direction X from a bottom portion of the core 51 connected to the metal disk 55 of the flange portion 46, and is wound on the core 51 from the intermediate portion R of the core 51 to a tip end portion Q of the core 51. One end 60 of the lead wire L penetrates through the metal disk 55 of the flange portion 46 from the bottom portion P of the core 51 to retreat outside the heater 41. The other end 61 of the lead wire L penetrates through the metal disk 55 through the inside of the core 51 from the tip end portion Q of the core 51, and retreats outside the heater 41. Heating by the heater 41 can be performed by causing the part of the core 51 from the intermediate portion R to the tip end portion Q to generate heat by passing a current from both the ends 60 and 61 of the lead wire L which are retreated outside.

As shown in FIGS. 6 and 7, the flange portion 46 of the heater 41A is fixed to the metal plate 36 of the heater panel 35 by a fixture 62 such as a screw, for example. In this embodiment, a screw constituted of a shaft portion including a thread and a head portion is used as the fixture 62. The fixtures 62 are provided at the flange portion 46 at the positions at the same height as the axis of the hole 40A so that each one of them is symmetrically at each of both sides of the hole 40. The fixtures 62 penetrate through the flange portion 46 of the heater 41A in the lengthwise direction X and threadedly connect the flange portion 46 and the metal plate 36. Thereby, the heater 41A inserted in the hole 40A is fixed. The flange portion 46 is provided with an annular groove 65, which is concentrically adjacent to an outer periphery of the metal tube 50, in a portion where the flange portion 46 is connected to the metal tube 50. A shown in FIG. 7, the annular groove 65 is fitted with an annular O-ring 66. Thereby, in the state in which the metal disk 55 of the flange portion 46 is pressed against the metal plate 36 of the heater panel 35 and fixed by the fixtures 62, the O-ring 66 is compressed and is closely in contact with both the metal disk 55 and the metal plate 36, and the inside of the hole 40A is hermetically sealed so as to prevent inflow and outflow of gas between the inside and outside of the hole 40A.

In this embodiment, in the hermetically sealed hole 40A, predetermined gas with high thermal conductivity such as air, for example, is filled in advance. Instead of filling gas, a certain heat-transfer material such as liquid may be filled in the hole 40A. Instead of filling gas, the inside of the hole 40A may be under vacuum.

As shown in FIG. 5, the heater panel 35 is provided with 18 temperature sensors 42 which measure temperature. In this embodiment, six of the 18 temperature sensors are disposed in a central portion in the longitudinal direction X of the heater panel 35, and 12 of them are disposed at both end portions in the longitudinal direction X. The six temperature sensors 42 disposed in the central portion of the heater panel 35 are respectively provided at intermediate positions between the tip end portions of the short heaters 41B. On the other hand, as for the 12 temperature sensors 42 disposed at both the end portions of the heater panel 35, six of them are placed at each of one end portion side and the other end portion side, and each of them is disposed in the central position in the lengthwise direction X of the short heater 41B. As shown in FIG. 5, the 12 temperature sensors 42 disposed at both the end portions are provided at the positions between the long heaters 41A and the short heaters 41B, which are adjacent to one another, every other position along the lateral direction Y.

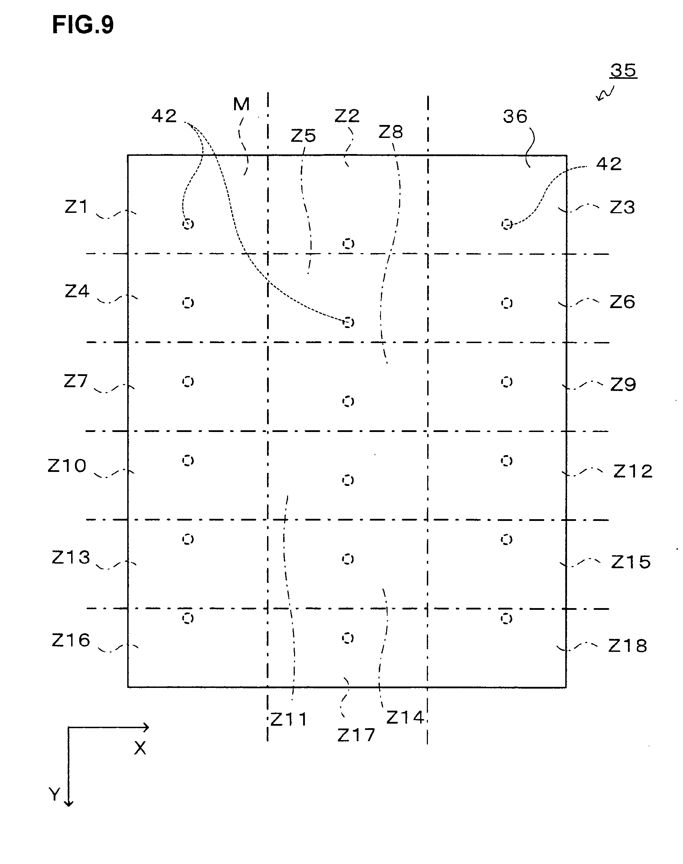

FIG. 9 is a schematic diagram showing the relationship of the temperature sensors 42 disposed on the heater panel 35 and heating zones Z1 to Z18 of which temperatures these temperature sensors 42 measure. In this embodiment, the top surface of the heater panel 35 is divided into the 18 rectangular heating zones Z1 to Z18 partitioned with seven dashed lines along the longitudinal direction X and the lateral direction Y as shown in FIG. 9. One temperature sensor 42 is disposed in each of the 18 heating zones Z1 to Z18. The 18 temperature sensors 42 respectively corresponding to the heating zones Z1 to Z18 of the heater panel 35 are connected to a control device 43 as shown in FIG. 5, so that the measurement result measured by each of the temperature sensors 42 is inputted into the control device 43.

The control device 43 is connected to all the heaters 41 (41A, 41B), and can individually control each of the heaters 41 to heat the heating zones Z1 to Z18 of the heater panel 35 uniformly based on information of the shape and size of the solar battery module M to be heated. The information of the shape and size of the solar battery module M includes the information as to on which heating zone of the 18 heating zones Z1 to Z18 of the heater panel 35 the solar battery module M is placed and the like. For example, in the case shown in FIG. 9, the solar battery module M is placed on all the heating zones Z1 to Z18. The information of the shape and size of the solar battery module M may be held in advance by the control device 43, or may be inputted therein from another input device (not shown) on the occasion of heating. In FIG 5, only part of the connection of the control device 43 and the temperature sensors 42 and only part of the connection of the control device 43 and the heater 41 are shown by simplifying them in order to make the drawing easy to see.

Next, a conveying system of the laminating apparatus 1 will be described. As shown in FIGS. 1 and 2, the conveying sheet 5 formed into an endless shape is constituted to circulate and pass above and below the lower case 12 of the laminate unit 3 by the operation of a conveying sheet moving mechanism 70. The conveying sheet 5 is formed into a long band shape. In the conveying sheet 5, only a part on which the solar battery module M is placed in the conveying direction may be formed in the band shape.

As shown in FIG. 2, the conveying sheet moving mechanism 70 includes rotary rolls 72 and 73 which circulatingly drive the conveying sheet 5, and guide rolls 75 and 76 which guide the conveying sheet 5. The rotary roll 72 is disposed at a lower side on the right of the lower case 12 of the laminate unit 3, whereas the rotary roll 73 is disposed at a lower side on the left of the lower case 12. Above the rotary roll 72, the guide roll 75 is rotatably disposed along the height of the upper edge of the right side of the lower case 12, whereas above the rotary roll 73, the guide roll 76 is rotataby disposed along the height of the upper edge of the left side of the lower case 12.

By rotationally driving the rotary rolls 72 and 73 in the counterclockwise direction in FIG. 2, the conveying sheet 5 can be let out from the rotary rolls 72 and 73 and circulated in the counterclockwise direction (FIG. 2). In this case, the conveying sheet 5 let out from the rotary roll 72 changes the direction to the horizontal direction along the circumferential surface of the guide roll 75, thereafter, passes above the lower case 12 of the laminate unit 3 in the leftward direction in FIG. 2, changes the direction to the downward direction along the circumferential surface of the guide roll 76, and advances to the rotary roll 73. As shown in FIG 2, by disposing the guide rolls 75 and 76 at the same height on the right and left of the laminate unit 3, the conveying sheet 5 can be supplied above the lower case 12 of the laminate unit 3 in the horizontal posture. The top surface of the conveying sheet 5 above the lower case 12 of the laminate unit 3, the top surface of the supply conveyor 6 and the top surface of the unloading conveyor 7 are disposed at heights which are substantially the same as one another.

On the other hand, by rotationally driving the rotary rolls 72 and 73 in the clockwise direction in FIG. 2, the conveying sheet 5 is let out from the rotary rolls 72 and 73 and can be circulated in the clockwise direction (FIG. 2). By rotating both the rotary rolls 72 and 73 in one direction like this, the conveying sheet 5 can be moved in a desired direction with the surface being substantially horizontal, and can be passed between the upper case 10 and the lower case 12 of the laminate unit 3.

The surface of the conveying sheet 5 is preferably formed of a material excellent in removability to which the filler does not easily attach or from which the attached filler can be easily removed, in order to avoid attachment of the filler which is squeezed out of the solar battery module M when sandwiched and pressed by the diaphragm 30 in the laminating part 2. For example, a heat-resistant glass cloth sheet or the like coated with Teflon (registered trademark) (fluorocarbon resin) or the like is preferably used as the conveying sheet 5. Alternatively, the surface of the conveying sheet 5 may be coated with a material excellent in removability such as a fluorocarbon resin, for example.

In the conveying sheet moving mechanism 70, the solar battery module M to be subjected to laminate treatment is placed on the top surface of the conveying sheet 5, on the right of the laminate unit 3, and the conveying sheet 5 is intermittently moved by rotational drive of the rotary rolls 72 and 73, whereby the solar battery module M can be moved in sequence between the upper case 10 and the lower case 12 of the laminate unit 3. Specifically, by moving the conveying sheet 5, the solar battery module M can be moved in sequence between the upper chamber 13 and the lower chamber 15 of the laminating part 2. While the solar battery module M is subjected to laminate treatment by being sandwiched by the upper chamber 13 and the lower chamber 15 of the laminate unit 3, the undersurface of the solar battery module M is supported by the top surface of the conveying sheet 5, and the conveying sheet 5 is intermittently moved, whereby the laminated solar battery module M is sequentially conveyed to the left of the laminate unit 3.

The diaphragm 30 is disposed above the solar battery module M which is placed on the conveying sheet 5 and conveyed into the laminating part 2 of the laminate unit 3, and the heater panel 35 is disposed below the solar battery module M and the conveying sheet 5. Between the upper case 10 and the lower case 12, the solar battery module M which is placed on the conveying sheet 5 can be raised and lowered by a raising and lowering mechanism (not shown) using the pin. Thereby, the solar battery module M is lifted up and raised to an upper position spaced by a predetermined distance from the heater panel 35, and can be lowered from the upper position to be returned onto the conveying sheet 5.

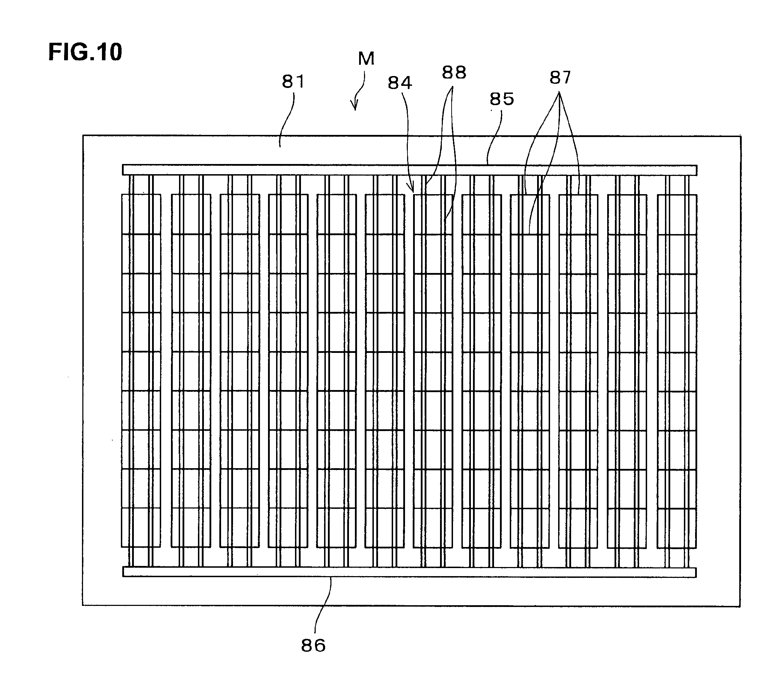

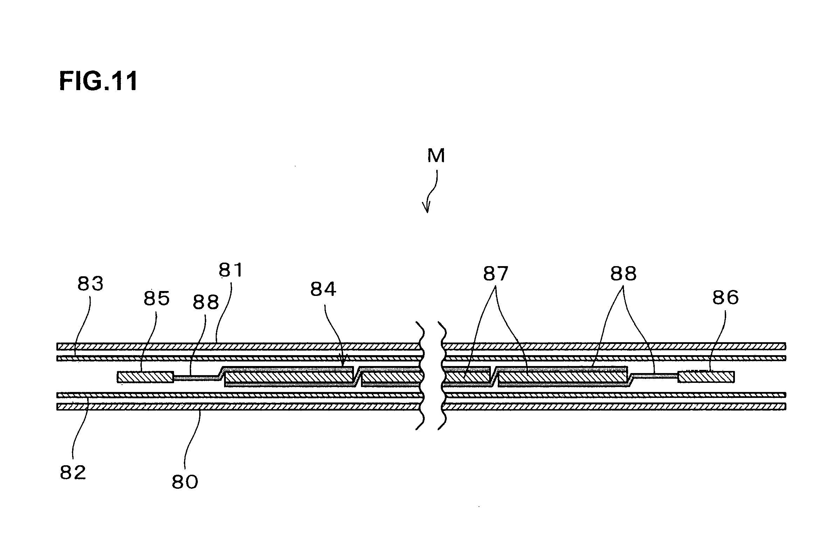

FIGS. 10 and 11 show the solar battery module M as one example of the laminated object which is favorably produced by the laminating apparatus 1 of the present invention. As shown in FIG. 10, the solar battery module M is formed into a rectangular thin plate shape, and is formed into a size of, for example, about 2150 mm × about 4000 mm.

As shown in FIG 10, the solar battery module M has a constitution in which a string 84 is sandwiched between a transparent cover glass 80 disposed on a lower side and a protective material 81 disposed on an upper side via fillers 82 and 83. As the protective material 81, for example, a transparent material such as a PE resin is used. As the fillers 82 and 83, for example, an EVA (ethylene vinyl acetate) resin or the like is used. The string 84 has a constitution in which solar battery cells 87 are connected between electrodes 85 and 86 via a lead wire 88. In the solar battery cell 87, a surface (light receiving surface) is covered with the cover glass 80 on the lower side, and a back surface is covered with the protective material 81.

The solar battery module M as the laminated object constituted as above is produced by the laminating apparatus 1 according to the embodiment of the present invention according to the following procedure.

### (Entire process)

First, in FIG.1, the solar battery module M to be laminated is positioned and supplied to the supply conveyor 6 by means such as a robot not shown. On the occasion of supply onto the supply conveyor 6 of the laminating apparatus 1, the solar battery module M is in the posture such that the protective material 81 shown in FIGS. 10 and 11 is located on the top surface side of the solar battery module M. Further, a short side direction of the solar battery module M is directed in the conveying direction (leftward direction in FIGS. 1 and 2). The solar battery module M thus placed on the supply conveyor 6 is conveyed leftward by the operation of the supply conveyor 6, and the solar battery module M is transferred to the conveying sheet 5 from the supply conveyor 6.

On the occasion of transferring the solar battery module M to the conveying sheet 5, the upper case 10 of the laminate unit 3 is lifted up, and the laminating part 2 is brought into an open state. The operation of lifting up the upper case 10 is performed by the extending operation of the cylinder 22 explained in FIG. 2. Thus, the conveying sheet 5 is in the state capable of advancing and retreating between the upper case 10 and the lower case 12 of the laminate unit 3. Subsequently, by advancing the conveying sheet 5 leftward above the lower case 12 by rotational drive of the rotary rolls 72 and 73 while operating the supply conveyor 6, the solar battery module M is transferred to the conveying sheet 5 from the supply conveyor 6, and the solar battery module M supplied onto the top surface of the conveying sheet 5 is further moved leftward.

When the solar battery module M is moved between the upper case 10 and the lower case 12 of the laminate unit 3, the rotational drive of the rotary rolls 72 and 73 is stopped, and movement of the conveying sheet 5 is stopped. In this way, in the laminate unit 3, the solar battery module M is caused to stand still between the upper chamber 13 of the upper case 10 and the lower chamber 15 of the lower case 12.

Next, the upper case 10 is lowered in the laminate unit 3, and the solar battery module M is brought into the state covered with the upper chamber 13, thereby bringing the laminating part 2 into the hermetically sealed state. In the laminate unit 3, the operation of lowering the upper case 10 is carried out by the contracting operation of the cylinder 22 described in FIG. 2. Thus, the solar battery module M is in the state housed in the laminating part 2 of the laminate unit 3.

Hereinafter, the laminate treatment of the solar battery module M in the laminate unit 3 will be described. First, in the laminate unit 3, the inside of the upper chamber 13 and the inside of the lower chamber 15 are evacuated at the same time through the inlet/outlet ports 31 and 37. While the inside of the upper chamber 13 and the inside of the lower chamber 15 are evacuated, the heater 41 is heated, and the heater panel 35 in the lower chamber 15 may be heated to a predetermined temperature in advance. If heating of the heater panel 35 is started with the inside of the lower chamber 15 decompressed while the solar battery module M on the conveying sheet 5 is raised by the operation of the raising and lowering mechanism not shown and is kept at an upper position away from the heater panel 35, the heat insulating effect is extremely high, and there is less fear of heat being transferred to the solar battery module M during decompression. After the inside of the upper chamber 13 and the inside of the lower chamber 15 are respectively evacuated to, for example, 0.7 to 1.0 Torr, the solar battery module M is lowered by the operation of the raising and lowering mechanism not shown inside the lower chamber 15, and is placed on the conveying sheet 5. Thereby, the solar battery module M placed on the conveying sheet 5 is in the state in which it thermally contacts the top surface of the heater panel 35 inside the lower chamber 15, and the solar battery module M is heated. By the heating, in the solar battery module M, chemical reaction of the EVA resin that is the fillers 62 and 63 is promoted, and cross linking is performed.

In this state, atmospheric pressure is introduced into the upper chamber 13 through the inlet/outlet port 31, and the diaphragm 30 is expanded downward in the laminating part 2, whereby the solar battery module M is sandwiched and pressed between the top surface of the heater panel 35 and the diaphragm 30. In this way, by the heating, and sandwiching and pressing, laminate treatment of the solar battery module M is performed.

While the laminate treatment of the solar battery module M is thus performed in the laminate unit 3, the next solar battery module M to be subjected to laminate treatment is preferably supplied onto the supply conveyor 6 and is made to stand by on the right of the laminate unit 3.

After the laminate treatment of the solar battery module M is finished, in the laminate unit 3, atmospheric pressure is introduced into the lower chamber 15 through the inlet/outlet port 37. The heating temperature of the heater 41 is adjusted, and the heater panel 35 is cooled to a predetermined temperature in preparation for the next laminate treatment. By lifting up the upper case 10, the laminating part 2 is brought into an open state. The operation of lifting up the upper case 10 is performed by the extending operation of the cylinders 22 described with FIG. 1. Thereby, the conveying sheet 5 is in the state of being able to advance and retreat between the upper case 10 and the lower case 12 of the laminate unit 3 again.

When the laminating part 2 of the laminate unit 3 is brought into the open state, the rotary rolls 72 and 73 are rotationally driven in the conveying sheet moving mechanism 70, and the conveying sheet 5 is moved leftward, whereby the solar battery module M is moved to the left of the laminate unit 3, and is transferred to the unloading conveyor 7 from the conveying sheet 5. In this way, the moment when the solar battery module M is moved leftward, the supply conveyor 6 is operated, and the solar battery module M kept standby on the supply conveyor 6 is moved leftward, and is transferred to the conveying sheet 5 from the supply conveyor 6. The next solar battery module M is moved between the upper case 10 and the lower case 12 of the laminate unit 3.

Thereafter, in the laminate unit 3, the same laminate treatment as the aforementioned laminate treatment of the solar battery module M is performed. Specifically, evacuation of the inside of the upper chamber 13 and the inside of the lower chamber 15, heating by the heating panel 35, and expansion of the diaphragm 30 are performed, and the next solar battery module M is sandwiched and pressed between top surface of the heater panel 35 and the diaphragm 30. Thus, by the heating and sandwiching and pressing, the laminate treatment of the next solar battery module M is performed.

The solar battery module M transferred to the unloading conveyor 7 is removed from the unloading conveyor 7 in sequence by means such as a robot not shown, and is conveyed to the next process. By repeating the above process, the solar battery modules M can be successively subjected to the laminate treatment.

### (Heater control when heating the object to be laminated)

When the solar battery module M that is an object to be laminated is heated by the heater 41 of the heater panel 35 in the above described entire process, the control device 43 controls the heaters 41 as follows.

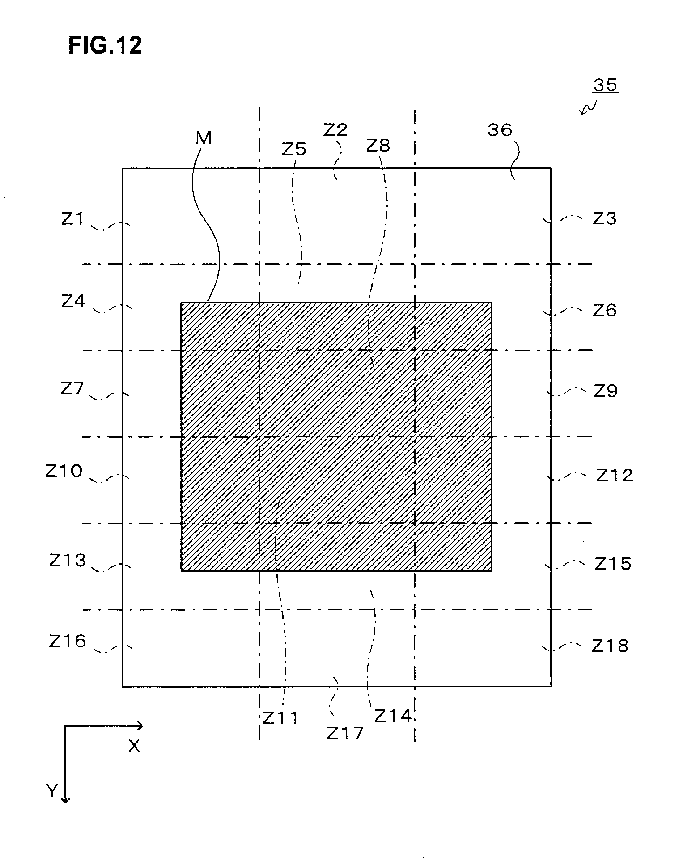

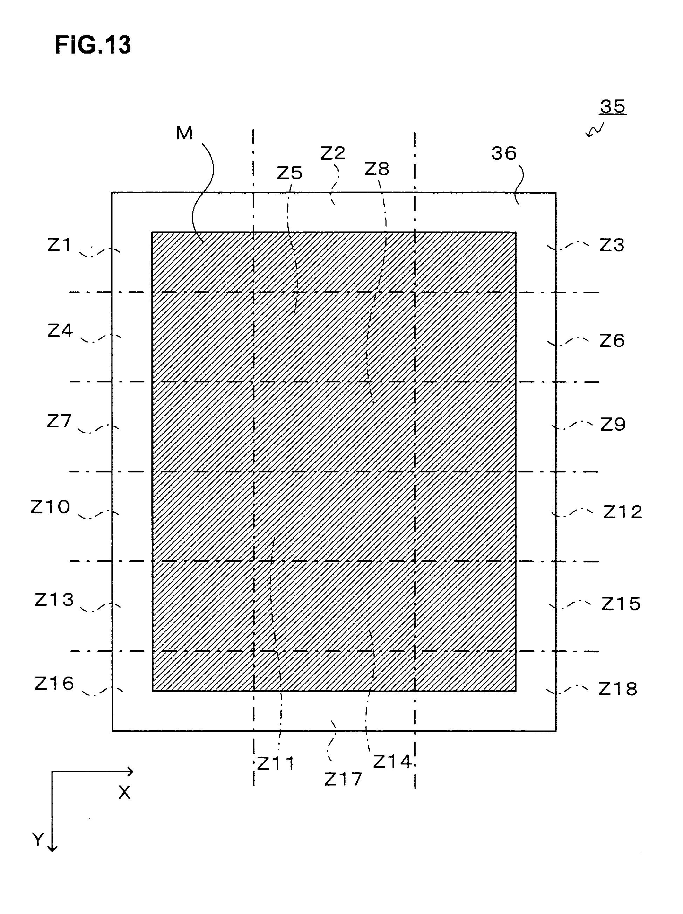

The control device 43 included by the laminating apparatus 1 holds the information of the shape and size of the solar battery module M in advance, or properly acquires it, and grasps the heating zones Z1 to Z18 of the heater panel 35 on which the solar battery module M is placed in advance on the occasion of heating. This will be described by using FIGS. 12 and 13. FIGS. 12 and 13 are explanatory views showing examples of the positional relationship of the heating zones Z1 to Z18 shown in FIG. 9 and the solar battery module M. For example, in the case of the solar battery module M shown in FIG. 12, the solar battery module M is placed on the heating zones Z4 to Z15 of the heating zones Z1 to Z18 shown in FIG. 9, and therefore, the control device 43 has the range information for them (Z4 to Z15). On the other hand, in the case of the one shown in FIG. 13, the solar battery module M is placed on all the heating zones Z1 to Z18 shown in FIG. 9, and therefore, the range information which the control device 43 has is about Z1 to Z18.

Control of the heaters 41 by the control device 43 is performed based on the measurement result measured by each of the temperature sensors 42 disposed in all the heating zones Z1 to Z18. When the measurement result of each of the temperature sensors 42 is inputted into the control device 43, the control device 43 takes out only the temperature information of the heating zones Z1 to Z18 on which the solar battery module M is placed from the measured result by using the aforementioned range information, and analyzes whether the temperatures of the heating zones Z1 to Z18 are uniform. The temperature information of not only the heating zones on which the solar battery module M is placed but also the heating zones around them may be analyzed.

The control device 43 individually controls each of the heaters 41 (41A, 41B) based on the analysis result, and adjusts the temperature by raising or lowering it so that ununiformity does not occur among the heating zones on which the solar battery module M is placed. For example, when the temperature of the heating zone Z8 in the central portion side of the heater panel 35 is higher than the temperatures of the heating zones Z7 and Z9 at both the end portion sides of the heater panel 35, the control device 43 reduces the output of the long heaters 41 A which heat the heating zone Z8 to lower the temperature, and increases the output of the heaters 41B which heat the heating zones Z7 and Z9 to raise the temperatures.

Subsequently, the control device 43 analyzes the temperature distribution among the heating zones after adjustment. When the temperatures among the heating zones are uniform, the control device 43 keeps the temperature of each of the heaters 41 (41A, 41B) as it is, and when the temperatures among the heating zones are ununiform, it raises or lowers the temperature of the heaters 41 and performs adjustment again. The control device 43 performs adjustment similarly hereafter so that the temperatures of the heating zones on which the solar battery module M is placed become uniform. When controlling each of the heaters 41, it is preferable to adjust the temperature based on information of the mutual disposition configuration of the heaters 41, the temperature sensors 42 and the heating zones Z1 to Z18, the disposition configuration with respect to the heater panel 35 and the like. Further, information concerning individual control of each of the heaters 41 carried out with respect to the measured result of the temperature sensors 42 (for example, to what extent the temperature adjustment of which heater 41 is performed with respect to the value of the predetermined temperature sensor 41, and the like) is obtained in advance, and each of the heaters 41 may be individually controlled by using the information.

According to the above embodiment, the top surface of the heater panel 35 is divided into a plurality of heating zones Z1 to Z18, the temperature sensor 42 which measures the temperature is provided in each of the heating zones, and a plurality of heaters 41 (41A, 41B) are individually controlled based on the measurement result, whereby suitable heating zones can be heated in accordance with the shape and size of the solar battery module M. The heaters 41 (41A, 41B) can be individually controlled so that the temperature of the heating zones on which the solar battery module M is placed becomes uniform. By the above, irrespective of the shape and size of the solar battery module M which is heated, the solar battery module M can be always heated uniformly, and various kinds of solar battery modules M can be properly produced. The quality of the solar battery module M which is produced is improved. Further, in the respect of being able to produce various kinds of solar battery modules M by using the same laminating apparatus 1, and in the respect of enhancing energy efficiency since unneeded heaters 41 do not have to be wastefully operated, a very economical effect is provided.

Further, as a plurality of heaters 41, pairs of long heaters 41A which perform heating at the central portion in the longitudinal direction X of the heater panel 35, and pairs of short heaters 41B which respectively perform heating at both the end portions are alternately disposed equidistantly along the lateral direction Y. Thereby, ununiformity of the temperature distribution due to the disposition configuration of the heaters 41 in the heater panel 35 can be eliminated, and heating more uniform than in the conventional laminating apparatus can be performed on the occasion of heating the solar battery module M.

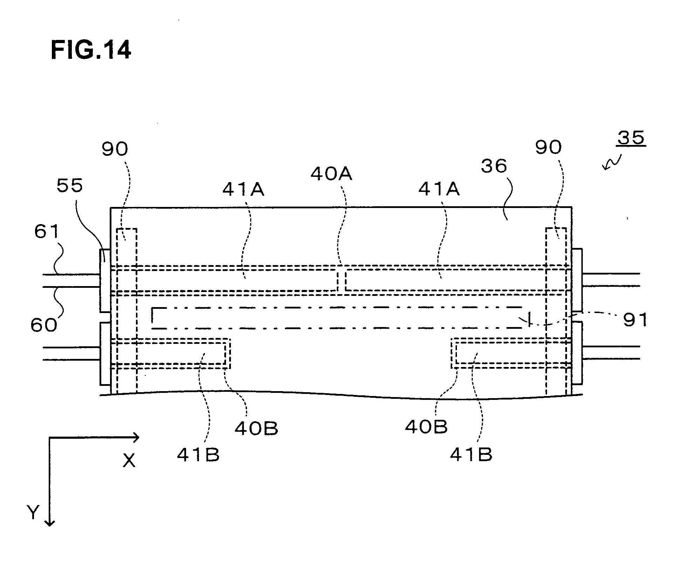

As a second embodiment of the present invention, auxiliary heaters 90 each in a lengthy shape may be disposed at the positions of both end portions in the longitudinal direction X on the undersurface of the heater panel 35 as shown in FIG 14. These auxiliary heaters 90 are disposed along the lateral direction Y of the heater panel 35 so as to be individually controlled by using the control device 43. Thereby, heating of both the end portions in the longitudinal direction X of the heater panel 35 is auxiliarily performed by using these auxiliary heaters 90, both the end portions which tend to be heated more insufficiently than the central portion in the longitudinal direction X of the heater panel 35 are reliably heated, and more uniform heating can be performed in the entire heater panel 35. The auxiliary heaters 90 may be regulated together on the occasion of controlling the heaters 41 to perform temperature regulation, or may be controlled independently from the control of the heaters 41.

Further, in the second embodiment of the present invention, as shown by the two-dot chain line in FIG. 14, a heat pipe 91 in a lengthy shape along the lengthwise direction X of the heater 41 is disposed on the undersurface of the heater panel 35. A fluid which performs heat transport is filled inside the hollow heat pipe 91, so that when the temperature ununiformity in the longitudinal direction X occurs to the heater panel 35, heat transport is performed in the direction to eliminate it. Thereby, on the occasion of heating the solar battery module M, more uniform heating can be performed in the longitudinal direction X of the heater panel 35. In FIG 14, only one heat pipe 91 is shown, but an optional number of heat pipes 91 may be used. The heat pipe 91 may be disposed along the lateral direction Y of the heater panel 35.

In the case of the second embodiment, the effect obtained in the first embodiment described by using FIG. 5 is similarly obtained.

The preferred embodiments of the present invention are described above with reference to the attached drawings, but the present invention is not limited to these examples. Those skilled in the art can obviously conceive various modified examples or revised examples within the scope of the technical idea described in "What is claimed is", and it is understood that they belong to the technical range of the present invention as a matter of course.

In the above described embodiments, the case of changing the inner pressure (specifically, evacuation or atmosphere introduction) of both the upper chamber 13 as the first space and the lower chamber 15 as the second space on the occasion of laminating the solar battery module M is described, but the inner pressure of only the lower chamber 15 may be changed.

In the above described embodiments, the case where a plurality of heaters 41 are constituted of the long heaters 41A and the short heaters 41B each in a lengthy shape is described, but the shapes of a plurality of heaters 41 may be optional shapes.

In the above described embodiments, the case where the pairs of the long heaters 41A opposed to each other on the same straight line parallel with the longitudinal direction X and the pairs of the short heaters 41B opposed to each other on the same straight line parallel with the longitudinal direction X are alternately disposed equidistantly along the lateral direction Y of the heater panel 35 is described, but an optional number of heaters 41 can be provided on the heater panel 35, and disposition of the heaters 41 can be optionally set.

In the above described embodiments, the case where the top surface of the heater panel 35 is divided into the 18 rectangular heating zones Z1 to Z18 is described, but the heater panel 35 may be divided into an optional number of heating zones in optional shapes. The case where the one temperature sensor 42 is provided in each of all the heating zones Z1 to Z18 is described, but an optional number of temperature sensors 42 may be provided in optional heating zones.

In the above described embodiments, production of the solar battery module is described as one example of the object to be laminated, but the laminating apparatus of the present invention can also apply laminate treatment to various things in addition to this, and is especially preferable for production of a laminated object in a thin plate shape. The laminating apparatus of the present invention also can be used for production or the like of an integrated module in which an external wall material or a roofing material for a building material and a solar battery module are integrated. Further, the laminating apparatus of the present invention can be used for production of laminated glass, ornamental glass and the like without being limited to the solar battery module.

In the above described embodiments, the case where the laminate treatment is performed by using the fixed heater panel 3 5 is described, but the laminate treatment may be performed by using the heater panel 3 5 which can be raised and lowered.

In the above described embodiments, the laminating part 2 including the diaphragm 30 above the solar battery module M and the heater panel 35 below the solar battery module M is described, but the constitution of the laminating part 2 is not limited to such a constitution. For example, it may be a constitution or the like which includes the heater panel above the solar battery module M and sandwiches and presses the solar battery module M by the heater panel and the conveying sheet.

In the above described embodiments, the size of about 2150 mm×4000 mm is shown as an example as the size capable of being laminated in the laminating part 2, and the size of about 2150 mm × 4000 mm is shown as an example as the size of the solar battery module M, but they are not limited to these sizes as a matter of course.

In the above described embodiments, the case where the heaters 41 provided on the heater panel 35 are cartridge heaters is described, but other heaters may be used.

The present invention is especially useful for the laminating apparatus which laminates objects to be laminated such as a light transmissive substrate, a filler, and a solar battery element, for example, and produces a solar battery module.

According to the present invention, the top surface of the heater panel which heats an object to be laminated is divided into a plurality of heating zones, the temperature of each of the heating zones is measured, and the heaters are individually controlled based on the temperature of each of the measured heating zones. Thereby, the object to be laminated can be always heated uniformly irrespective of the shape and size of the laminated object to be produced. As a result, various kinds of objects to be laminated are properly heated, and the quality of them can be improved more than the conventional ones. Various kinds of laminated materials can be produced by using the same laminating apparatus, which is very economical.

## Claims

1. A laminating apparatus which heats, and sandwiches and presses an object to be laminated, comprising:
a heater panel including a plurality of heaters inside;
temperature sensors each disposed in part or all of a plurality of heating zones formed by dividing a top surface of said heater panel; and
a control device which individually controls the plurality of heaters based on a measurement result of said temperature sensors.

2. The laminating apparatus according to claim 1,
wherein the object to be laminated is a solar battery module.

3. The laminating apparatus according to claim 1,
wherein the plurality of heaters are heaters each in a lengthy shape disposed to be parallel with each other inside said heater panel.

4. The laminating apparatus according to claim 1,
wherein the plurality of heaters are constituted so that heaters which perform heating in a central portion of said heater panel and heaters which perform heating at both end portions are alternately disposed along a predetermined direction.

5. The laminating apparatus according to claim 1,
wherein the plurality of heating zones include at least a heating zone in a central portion and heating zones at both end portions of said heater panel.

6. The laminating apparatus according to claim 1,
wherein an auxiliary heater individually controllable based on the measurement result of said temperature sensors is provided on an undersurface of said heater panel.
